# EUROPEAN PATENT APPLICATION

(11) **EP 2 866 266 A1**
(43) Date of publication of application: **29.04.2015**
(21) Application number: 13807231.9
(22) Date of filing: 18.06.2013
(51) Int. Cl.: H01L 31/042

(54) **SOLAR CELL MODULE**

(30) Priority: 22.06.2012 JP 2012140483
(71) Applicant: Panasonic Intellectual Property Management Co., Ltd., Osaka-shi, Osaka 540-6207 (JP)
(72) Inventor: TSUJIMURA, Hideyuki, Osaka-shi, Osaka 540-6207 (JP); OHASHI, Naomichi, Osaka-shi, Osaka 540-6207 (JP)
(74) Representative: Vigand, Philippe
(86) International application number: PCT/JP2013/003776
(87) International publication number: WO 2013/190823

(57) **Abstract**

To provide a solar cell module formed by a lamination structure in which a lower sealing portion (101) having a total light reflectance of 50% or more is arranged on a back sheet (106) side with respect to a solar cell device (103) and an upper sealing portion (102) having a total light transmittance of 50% or more is arranged on a solar-light irradiation surface side with respect to a solar cell device (103), and a porous body (104) is interposed between the lower sealing portion (101) and the solar cell device (103). To further provide a solar cell module in which an opening is formed in the porous body and the solar cell device is positioned in the opening.

## Description

### TECHNICAL FIELD

The present invention relates to a structure for providing a solar cell device in a solar cell module.

### BACKGROUND ART

The solar cell module is rapidly attracting attention as a safe and clean energy source which can be used instead of nuclear power generation. A public undertaking of large scale solar construction has begun at last in recent years. The solar cell module is also becoming common in ordinary houses for private use.

However, the solar cell module has not become common in many ordinary houses as it is difficult to generate a sufficient amount of power for replacing the conventional power generation and equipment is expensive. As reasons for that, conversion efficiency of solar cells is low at 20%, and productivity of the solar cell module is low.

Concerning improvement in conversion efficiency of the solar cells, study and development have been made night and day in universities and companies, making an effort to improve conversion efficiency as much as possible.

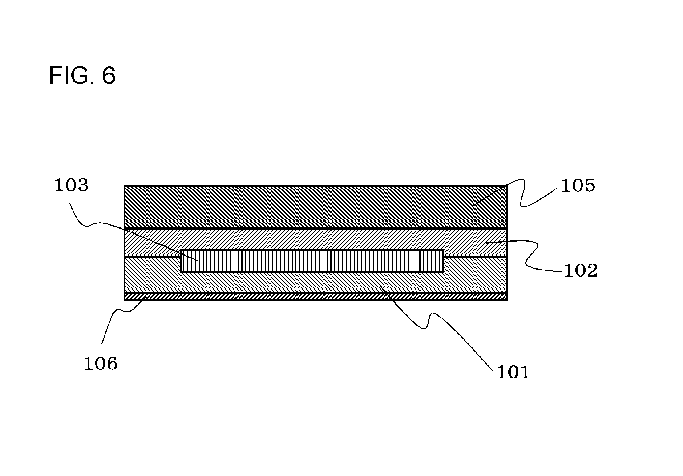

Next, a structure of the solar cell module will be explained before considering the productivity of the solar cell module. A cross sectional view of the solar cell module which is commonly used is shown in Fig. 6.

A solar cell device 103 made of silicon, gallium-arsenic, copper-indium-selenium and so on is fixed by being sandwiched between a lower sealing portion 101 and an upper sealing portion 102, and further, a surface glass plate as an uppermost protective member 105 is arranged in a solar light irradiation side and a back sheet 106 is arranged in a back surface, thereby packaging the module.

As sealing materials (the lower sealing portion 101 and the upper sealing portion 102) for solar cells, transparency is necessary for guiding light to the solar cell device 103. It is also necessary that the material has a good adhesive property with respect to the upper and lower respective protective members as the module is installed outdoors. As the sealing material, for example, an ethylene-vinyl acetate copolymer with a high vinyl acetate content is frequently used from standpoints of flexibility, transparency and so on. A structure in which such sealing material is arranged above and below the solar cell device 103 as shown in Fig. 6 is used most frequently.

Moreover, as a structure for increasing a light collection ratio of solar light, an aluminum thin-film is laminated or a metal film is deposited on the back sheet 106 arranged in the back surface, thereby reflecting solar energy transmitted between the solar cell device 103 and the film as well as the solar cell device 103 to increase conversion efficiency as much as possible.

As another method, an attempt to improve irradiation efficiency is performed by allowing the lower sealing portion 101 arranged in the back surface side with respect to a solar light irradiation surface of the solar cell device 103 to contain a solar light reflection material such as titanium oxide to thereby reflect solar light.

As a cause of deterioration of the solar cell module, moisture penetration can be cited. That is, moisture is penetrated from the back sheet 106 side as the back surface, which affects the solar cell device 103, electrically bonded tabs and solder at bonded portions, and may cause hydrolytic cleavage, oxidation deterioration of the sealing material and so on. As prevention measures, to arrange an aluminum film in the back sheet 106, to allow an additive for preventing penetration of moisture to be contained in the lower sealing portion 101, or to arrange a material containing an antioxidant and to use a material with low transparency for preventing deterioration of the sealing material itself.

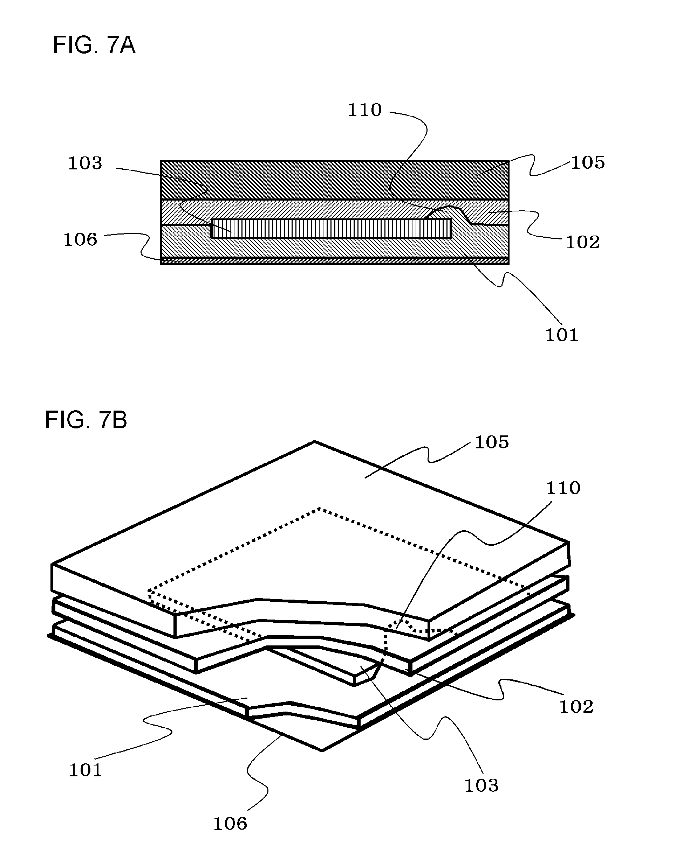

Concerning the manufacturing of the solar cell shown in Fig. 6, the lower sealing portion 101 may enter the solar light irradiation side (uppermost protective member 105 side) in a laminating process of the upper sealing portion 102 and the lower sealing portion 101. The condition is shown in Fig. 7A and Fig. 7B. Fig. 7A is a cross-sectional view of the solar cell module and Fig. 7B is a perspective view of the solar cell module which is partially exploded.

The lower sealing portion 101 is mixed into the upper sealing portion 102 and a protruding portion 110 is put over an upper surface of the solar cell device 103. In this case, when the additive for reflecting light is contained in the lower sealing portion 101, light is shielded and light to be irradiated to the solar cell device 103 is reduced, which decreases the efficiency.

The solar cell module is heated according to use environment, and flowage occurs in the sealing material in the module when the temperature is increased, which generates the protruding portion 110 as described above.

### CITATION LIST

### PATENT LITERATURE

PTL 1: JP-A-2012-004146

### SUMMARY OF INVENTION

In order to solve the above problems, there is provided a solar cell module including a back sheet, a first sealing portion positioned over the back sheet, a porous body provided over the first sealing portion, a solar cell device positioned over the porous body, a second sealing portion positioned over the solar cell device and an outer protective portion positioned over the second sealing portion.

In the present invention, an opaque lower sealing material does not protrude to a solar light irradiation surface side of the solar cell device by the lamination structure in which the porous body is interposed between two sealing materials. It is possible to maintain the lamination structure of the laminated sealing materials. Furthermore, the softened lower sealing material does not easily flow in a reliability test in which heat is applied from the outside such as a heat cycle test. As a result, it is possible to realize the solar cell module in which a failure due to generation of the protruding portion of the opaque lower sealing material does not easily occur and power generation efficiency is not reduced.

### BRIEF DESCRIPTION OF DRAWINGS

[Fig. 1] Fig. 1 is a solid view showing a lamination structure of a solar cell module according to Embodiment 1.
[Fig. 2A] Fig. 2A is a cross-sectional view showing the lamination structure of the solar cell module according to Embodiment 1.
[Fig. 2B] Fig. 2B is an enlarged view of a dashed line portion of Fig. 2A.
[Fig. 3A] Fig. 3A is a solid view showing a lamination structure of a solar cell module according to Embodiment 2.
[Fig. 3B] Fig. 3B is a view showing a shape of an opening in a porous body according to Embodiment 2.
[Fig. 4A] Fig. 4A is a cross-sectional view showing a lamination structure of a solar cell module according to Example 2 of Embodiment 2.
[Fig. 4B] Fig. 4B is an enlarged view of a dashed line portion of Fig. 4A.
[Fig. 5] Fig. 5 is a cross-sectional view showing a lamination structure of a solar cell module in a case where a void is generated when a sealing material is not infiltrated into a nonwoven fabric.
[Fig. 6] Fig. 6 is a cross-sectional view showing a lamination structure of a related-art solar cell module.
[Fig. 7A] Fig. 7A is a cross-sectional view showing a lamination structure of the related-art solar cell module in a case where an opaque sealing material covers a solar light irradiation surface.
[Fig. 7B] Fig. 7B is a solid view showing the lamination structure of the related-art solar cell module in the case where the opaque sealing material covers the solar light irradiation surface.

### DESCRIPTION OF EMBODIMENTS

### (Embodiment 1)

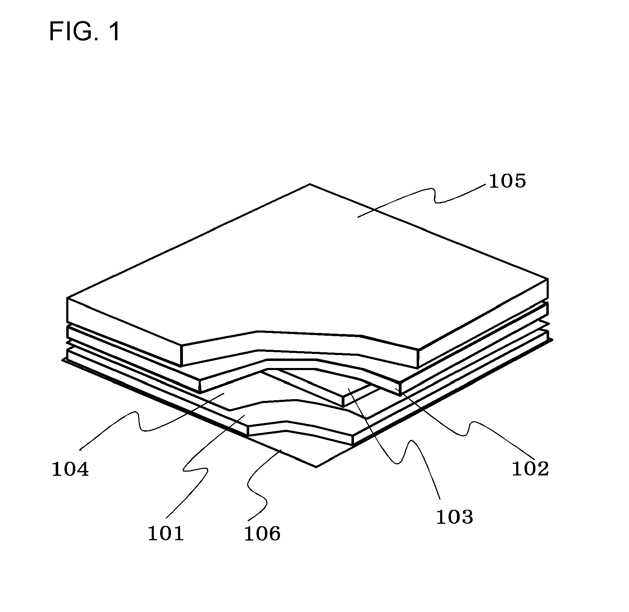

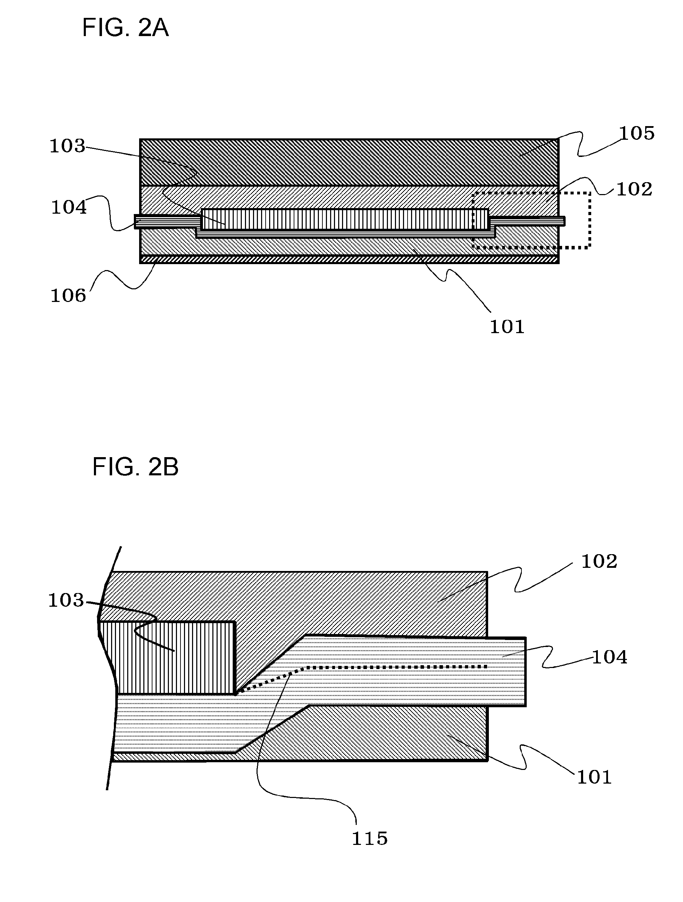

Fig. 1 is a perspective view showing a state where part of a solar cell module according to Embodiment 1 is peeled, Fig. 2A is a cross-sectional view thereof and Fig. 2B is a cross-sectional view obtained by enlarging a portion surrounded by dotted lines of Fig. 2A.

The solar cell module according to Embodiment 1 includes a solar cell device 103, an upper sealing portion 102 positioned over the solar cell device 103, a porous body 104 positioned below the solar cell device 103, a lower sealing portion 101 positioned below the porous body 104, an uppermost protective member 105 positioned over the upper sealing portion 102 and a back sheet 106 positioned below the lower sealing portion 101.

The solar cell device 103 is sandwiched between the upper sealing portion 102 and the lower sealing portion 101. A dotted line of Fig. 2B denotes an interface 115 between the upper sealing portion 102 and the lower sealing portion 101.

Vacuum lamination is performed in a state where the solar cell device 103 is sandwiched by the sheet-shaped upper sealing portion 102, the sheet-shaped porous body 104 and the sheet-shaped lower sealing portion 101, and the sheet-shaped uppermost protective member 105 and the sheet-shaped back sheet 106 are laminated above and below the solar cell device 103, thereby forming the solar cell module.

In the upper sealing portion 102 used in Embodiment 1, a high-polymer material having a total light transmittance of at least 50% or more is used. When the transmittance is lower than 50%, a ratio in which light reaches the solar cell device 103 is low, which is not suitable to be used. Therefore, the upper sealing portion 102 preferably use a material with a transparency as high as possible. On the other hand, the lower sealing portion 101 is positioned below the solar cell device 103, and a high total light transmittance is not necessary. The lower sealing portion 101 uses a high-polymer material having better bonding property with respect to the upper sealing portion 102.

As the high-polymer material commonly used as the sealing material, a material mainly containing an ethylene-vinyl acetate copolymer (EVA) is used. In the lower sealing portion 101, a material obtained by adding an ultraviolet-light reflection filler such as titanium oxide into the material mainly containing ethylene-vinyl acetate copolymer (EVA) to thereby allow solar light to be easily reflected is used.

Other resin components for the sealing portions, an ethylene-unsaturated carboxylic acid copolymer or an ionomer thereof, a silicone resin, polyvinyl-butyral, a thermoplastic polyurethane resin, a polyolefin resin and so on can be cited, and it is also preferable to use the above materials for the lower sealing portion 101 and the upper sealing portion 102 by combining these materials for utilizing characteristics of materials.

Furthermore, a material obtained by adding an antioxidant, a photostabilizer, an ultraviolet absorber, a coloring agent, a light diffusion agent, a flame retardant, an antitarnish agent, a silane coupling agent and so on can be additionally used for the lower sealing portion 101 for improving durability.

The porous body 104 is preferably a porous sheet, and it is particularly preferable to use an organic nonwoven fabric. As the organic nonwoven fabric, a long-fiber nonwoven fabric as well as a short-fiber nonwoven fabric made of polyethylene terephthalate fibers, polyolefin fibers, or a fabric formed by entangling these two or more kinds of fibers can be used. A spunbonded-nonwoven fabric, a wetted-nonwoven fabric, a needle nonwoven fabric and the like can be used.

It is preferable to use a material having an SP value close to the sealing material as the fiber material to be selected, which will be explained in detail in the following examples. When the difference of SP values between the sealing material of the lower sealing portion 101 and the sealing material of the upper sealing portion 102 is large, two or more kinds of organic fibers having SP values close to respective sealing materials are combined to thereby form the porous body 104.

Particularly, it is preferable to use the fiber material in which the difference of SP values between the sealing materials and the organic fibers is 1.0 or less, because affinity between the sealing materials with respect to the organic nonwoven fabric is increased, and the fluidity of the sealing materials can be suppressed in the laminating process or when used at a high temperature.

Here, a solution parameter (SP value) is a value defined by a regular solution model introduced by Hildebrand, which is the value giving an indication of solubility of a binary solution. The value is also called a solubility parameter, a solution property parameter and a Hildebrand parameter.

In the regular solution model, as it is assumed that a force acting between a solvent and a solute is only an intermolecular force, the solution parameter is used as a gauge indicating the intermolecular force. Though an actual solution is not always the regular solution, but it is empirically known that the solubility is increased as the difference of SP values between two components is reduced.

The porous body 104 is preferably the porous sheet, not limited to the nonwoven fabric, and further preferably has the SP value in a range described above. The sheet formed by weaving various kinds of fibers is preferably used.

The porous body 104 is not limited to the nonwoven fabric, and a fabric formed by weaving fibers regularly such as a plain weave, a twill weave, a satin weave, leno, nock leno, an oblique weave and a double weave is preferably used.

A shape of the porous body 104 is not particularly limited, but a fiber diameter thereof is preferably 10µm or more to 100µm or less and a fiber apparent density is preferably 0.05g/cm³ or more to 0.3g/cm³ or less in consideration of infiltration property of the sealing material with respect to the inside of the porous body 104. The reason thereof will be explained in the following example.

The sealing material of the upper sealing portion 102 and the sealing material of the lower sealing portion 101 respectively enter the porous body 104 to the interface 115 shown by the dotted line of Fig. 2B. The porous body 104 is preferably arranged so that an outer periphery thereof reaches an outer surface of the solar cell module. That is because the sealing material of the upper sealing portion 102 and the sealing material of the lower sealing portion 101 preferably do not directly contact each other.

### (Embodiment 2)

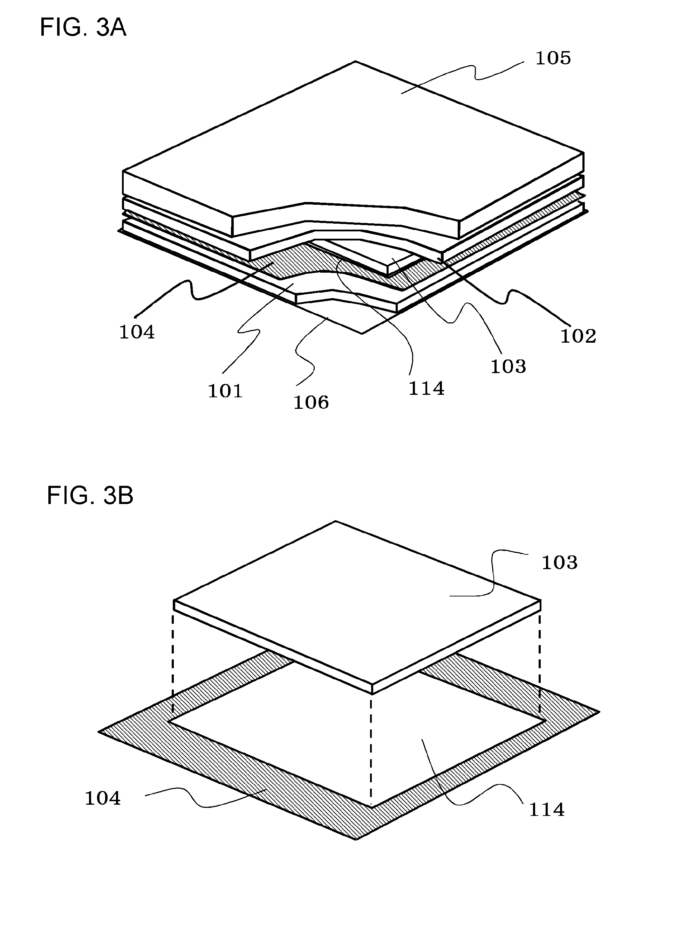

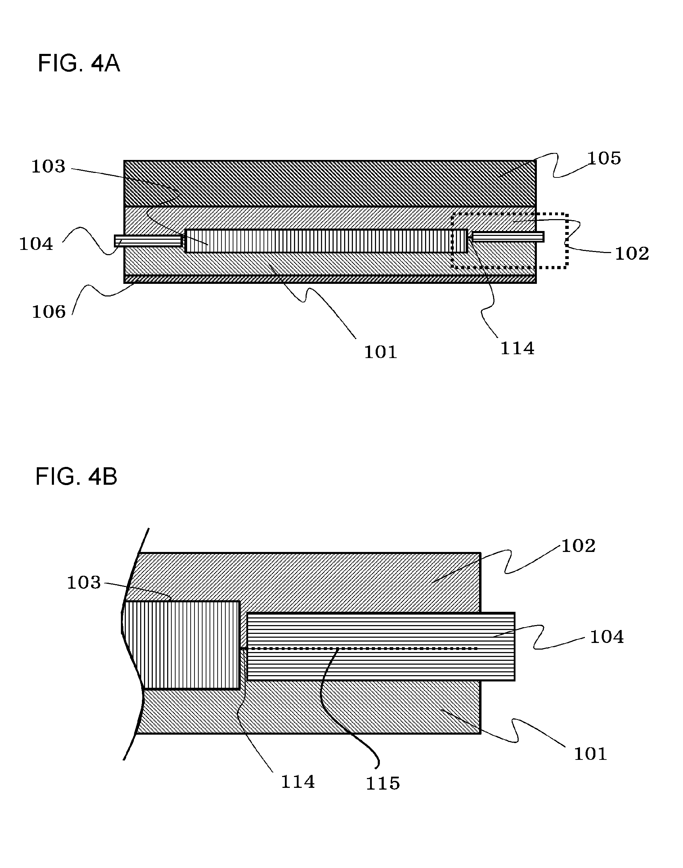

In Embodiment 2, a portion in which the solar cell device 103 is inserted is provided as an opening in the porous body 104. The opening will be explained with reference to Fig. 3A, Fig. 3B, Fig. 4A and Fig. 4B. Components not to be explained are the same as those of Embodiment 1.

Fig. 3A is a perspective view obtained by breaking a corner portion of the solar cell module. Fig. 3B is an exploded view for explaining the relation between the solar cell device 103 and the porous body 104. Fig. 4A is a cross-sectional view of the solar cell module and Fig. 4B is an enlarged cross-sectional view of a portion surrounded by dotted lines of Fig. 4A. A dotted line in Fig. 4B is an interface 115 between the sealing material of the upper sealing portion 102 and the sealing material of the lower sealing portion 101. A sealing resin enters the porous body 104.

An opening 114 is provided in the porous body 104 as shown in Fig. 3B, and the size of the opening 114 is larger than the size of the solar cell device 103 in a surface direction. Part of the sealing material of the upper sealing portion 102 and part of the sealing material of the lower sealing portion 101 contact at one portion through the opening 114 and bond to each other when they are laminated.

The portion is a peripheral portion of the solar cell device 103. The portion is kept to the minimum as small as possible, because it is preferable that the sealing material of the upper sealing portion 102 and the sealing material of the lower sealing portion 101 do not directly contact each other. When they directly contact each other, the resin does not easily enter the porous body 104.

The porous body 104, the upper sealing portion 102 and the lower sealing portion 101 preferably have a sheet shape in the same manner as in the case of the structures Fig. 1, Figs. 2A and 2B. It is also preferable that the porous body 104 has a larger area than the upper sealing portion 102 and the lower sealing portion 101, and that the upper sealing portion 102 and the lower sealing portion 101 are not directly bonded in an outer peripheral side surface of the solar cell module. The reason thereof is that the resin does not easily enter the porous body 104 and that the entire strength is not increased when the porous body 104 is not used as described above.

### (Manufacturing Process)

Next, the solar cell is modularized by using a heat lamination method in which the sealing material of the upper sealing portion 102 and the sealing material of the lower sealing portion 101 are bonded by thermocompression in a temperature range in which the sealing materials can be softened and flow. The lamination is preferably performed in vacuum. A lamination method in the atmosphere is not suitable as a void is easily involved inside the porous body 104.

Furthermore, it is possible to use a laminated body in which the lower sealing portion 101 and the porous body 104 are previously bonded to perform sealing of the solar cell device 103 before the lamination of the solar cell module. For example, the lower sealing portion 101 is pushed from one side and coated by using the porous body 104 as a base material, thereby forming a sealing material sheet having the porous body on one side. It is preferable to use the above structure as the positional displacement in the laminating process of the porous body 104 or variation in tensile force can be solved.

As the solar cell device 103, various types of solar cell devices can be used, for example, ones made of silicon-based materials such as single-crystal silicon, polycrystal silicon and amorphous silicon, III-V or II-VI compound semiconductors such as gallium-arsenic, copper-indium-selenium and cadmium-tellurium. The sealing materials used in Embodiments 1 and 2 can be applied for sealing all types of the solar cell devices cited above.

As the uppermost protective member 105, a glass plate, an acrylic resin, a polycarbonate resin, a polyester resin, a fluorine-containing resin and so on can be used.

As the lowermost back sheet 106, a single layer or multilayer sheet such as various types of thermoplastic resin films can be used. In consideration of the gas barrier property or the moisture permeability, multilayer sheets including, for example, metal such as tin, aluminum and stainless steel, polyester in which an inorganic material such as glass is laminated, inorganic-vapor deposition polyester, the fluorine-containing resin and polyolefin can be used.

### (Evaluation Method)

As an evaluation method, evaluation is performed based on a residual ratio of a light collection area of the solar cell device 103 by measuring the area as a visual inspection. Also, measurement using an ultrasonic depth measurement device (SAT) is performed. The evaluation is further performed by the number of generated voids. The evaluation is specifically performed as follows.
(1) As evaluation in the modularized state, the light collection area of the solar cell device 103 which is seen in the modularized state is calculated with respect to an area of the solar light irradiation surface of the solar cell device 103 before modularization. The residual ratio 99% or more of the light collection area scores two points, the residual ratio of 95% or more to lower than 99% scores one point and the residual ratio lower than 95% scores zero points.
(2) After the heat cycle test is performed 200 cycles to the solar cell module at -40/120°C, the light collection area of the solar cell device 103 is calculated, then, zero to two points are scored according to the residual ratio of the light collection area in the same manner as (1).
(3) A void volume is measured by the ultrasonic depth measurement device (SAT) for evaluating adhesion between the upper sealing portion 102 and the lower sealing portion 101 after lamination in the modularization of the solar cell, and one point is scored when there is no void and zero points are scored when there is a void.
(4) The generation status of voids is evaluated after the heat cycle test is performed 200 cycles to the solar cell module, and one point is scored when there is no void and zero points are scored when there is a void.

The evaluation was performed by the total points (six is the best) of the above four evaluations.

The evaluation is passed by two or more points in (1) and (2), and the evaluation is passed by one or more points in (3) and (4). When all items are satisfied, the module is passed as a product. Conditions and results are shown in Table 1.

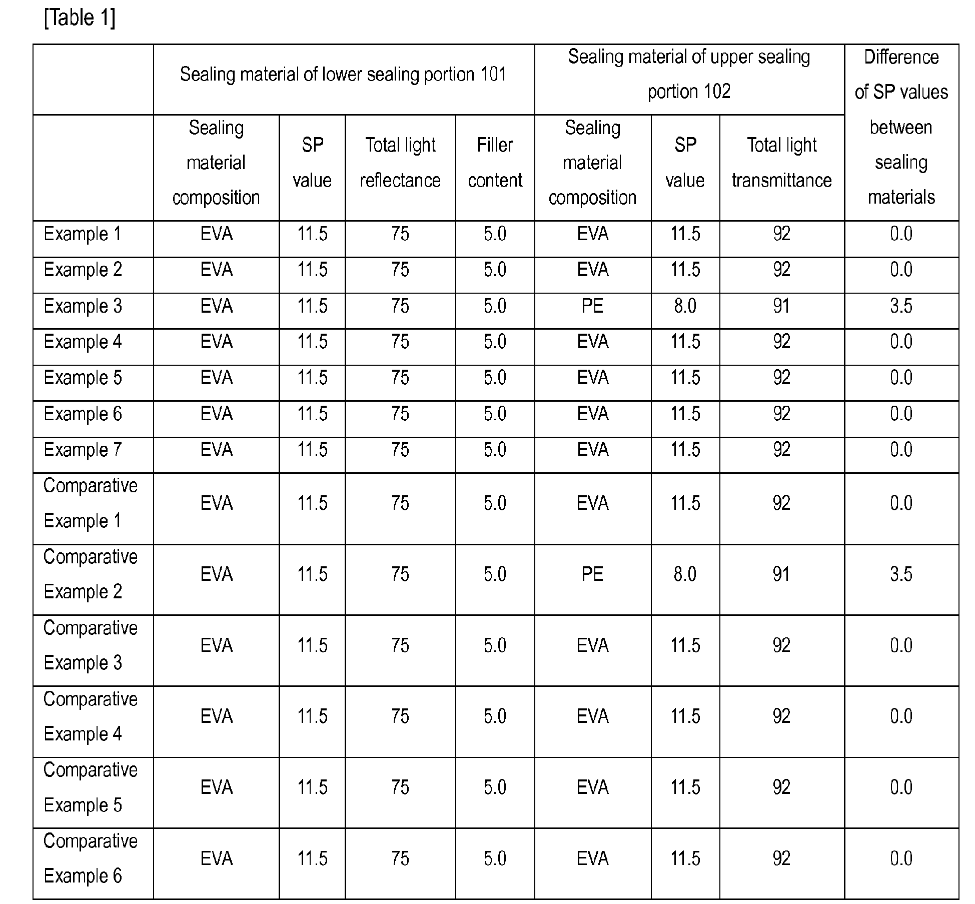

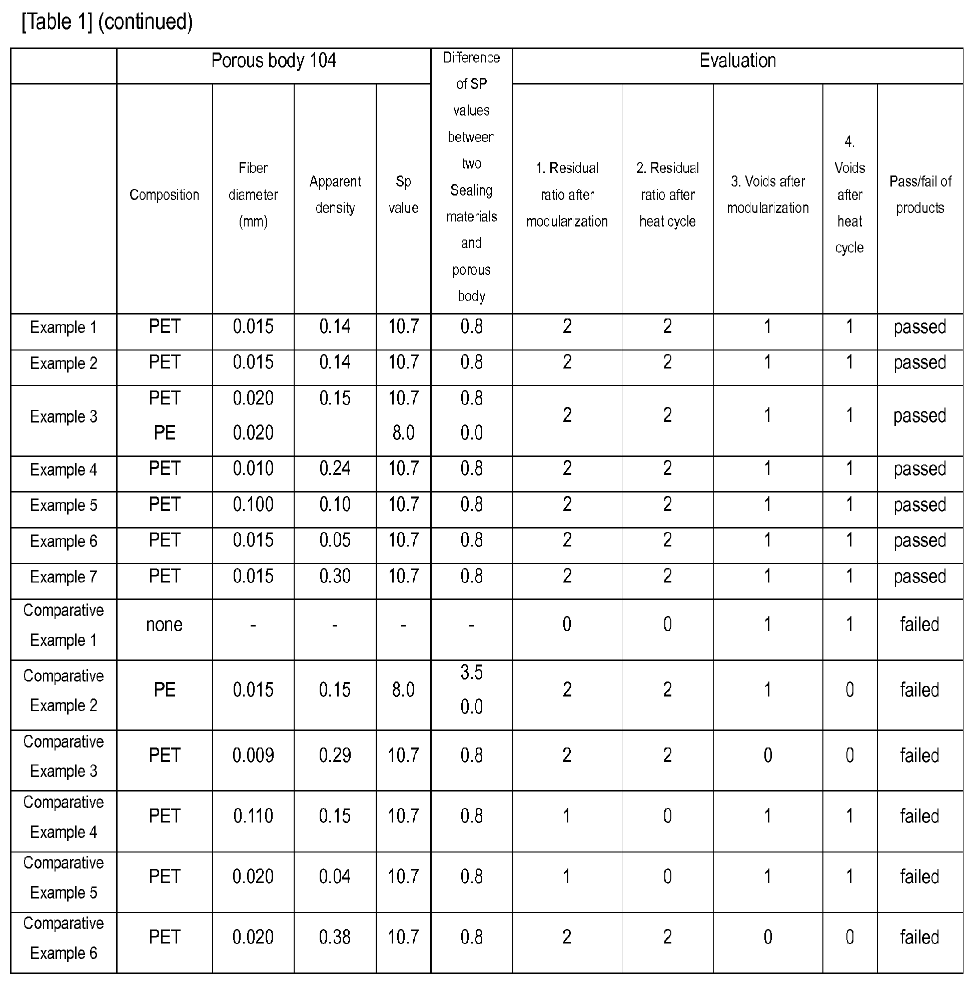

Hereinafter, specific explanation will be made based on examples and comparative examples. The present invention is not limited to these examples. In the following explanation, description parts such as physical property are written in Table 1 and omitted. The porous bodies 104 having thicknesses of 0.06 to 0.25mm were used. It is sufficient that the sealing materials enter the porous bodies, and characteristics were not affected.

### (Example 1)

As the sealing material of the upper sealing portion 102, the ethylene-vinyl acetate copolymer (EVA) sheet with a total light transmittance of 92% (measured by Haze Meter-HR-100 manufactured by MURAKAMI COLOR RESEARCH LABORATORY) was used. As the sealing material of the lower sealing portion 101, a sealing material obtained by allowing the ethylene-vinyl acetate copolymer to contain 5wt% rutile-type titanium dioxide with a total light reflectance of 75% (measured by Haze Meter-HR-100 manufactured by MURAKAMI COLOR RESEARCH LABORATORY) was used.

Subsequently, a polyester spunbond as an organic nonwoven fabric was used for the porous body 104.

As a lamination method, the EVA sheet with the total light transmittance of 92% as the sealing material of the upper sealing portion 102 was put on a white-plate tempered glass as the uppermost protective member 5, and the solar cell device 103 was put thereon. Next, the polyester spunbond as the organic nonwoven fabric was overlaid as the porous body 104, then, the white EVA sheet containing titanium dioxide as the sealing material of the lower sealing portion 101 was put, and a polyester film having a thickness of 0.1mm was arranged as the back sheet 106. The solar cell module was made by using the vacuum lamination molding (molding temperature 150°C, load 1000kg.m2).

After performing a visual inspection of lamination and a heat cycle reliability test of the obtained solar cell module, a visual inspection and evaluation of void generation were performed.

### (Result)

In the obtained solar cell module, the white lower sealing portion 101 was arranged on a back surface of the solar cell device 103 and the lamination could be performed so as not to cover the solar light irradiation surface of the solar cell device 103. Even after the heat cycle test was performed 200 cycles, movement due to the flowage of the sealing material of the lower sealing portion 101 to the solar light irradiation surface of the solar cell device 103 was not recognized.

### (Example 2)

The porous body 104 was shaped so as to have an opening of the same area as the area of the solar cell device 103 in a part where the solar cell device 103 was arranged as shown in Fig. 3A and Fig. 3B and laminated so that the solar cell device 103 was fitted thereto. The solar cell module was made in the same manner as Example 1 except for that point.

### (Result)

As the position of the obtained solar cell device 103 was fixed by the porous body 104, displacement did not occur at the time of lamination, the sealing material of the lower sealing portion 101 did not cover the solar light irradiation surface and no voids were generated. The flowage of the lower sealing portion 101 such as the covering did not occur even after the heat cycle test.

### (Example 3)

Polyethylene with a transparency of 91%, a solubility parameter SP value of 8.0 was used for the sealing material of the upper sealing portion 102, a white material obtained by allowing the ethylene-vinyl acetate copolymer to contain 5wt% titanium dioxide (SP value 11.5, total light reflectance 75%) was used for the sealing material of the lower sealing portion 101, and further, a needle nonwoven fabric (apparent density 0.15g/cm³, SP values (respective fabrics) 8.0, 10.7) was used for the porous body 104, which was obtained by mixing polyethylene short fibers (SP value 8.0) with a fabric diameter 20µm as an organic nonwoven fabric to polyester short fibers (SP value 10. 7) with a fabric diameter 20µm.

### (Result)

In the obtained solar cell module, the irradiation area could be secured as the white material of the sealing material for the lower sealing portion 101 did not cover the solar light irradiation surface and generation of voids was not recognized. As the fibers in which the difference of SP values with respect to respective sealing materials is 1.0 or less were entangled, infiltration and adhesion between two kinds of sealing materials and the porous body 104 was good and the flowage of the sealing materials did not occur even in the 200 cycles heat cycle reliability test.

### (Example 4)

The solar cell module was made in the same manner as Example 1 except for a point that a polyester spunbond having a different fabric diameter was used as the organic nonwoven fabric for the porous body 104.

### (Result)

The solar cell module obtained after the lamination molding was molded so that the white sealing material of the lower sealing portion 101 did not protrude to the solar light irradiation surface of the solar cell device 103, and so that a residual ratio was 100% with respect to the surface area of the solar cell device 103 before modularization without voids and flowage after the heat cycle test, that is, the condition was good.

### (Example 5)

A polyester spunbond having a different fabric diameter was used as the organic nonwoven fabric for the porous body 104. The solar cell module was made in the same manner as Example 1 except for that point.

### (Result)

The solar cell module obtained after the lamination molding was molded so that the white sealing material of the lower sealing portion 101 did not protrude to the solar light irradiation surface of the solar cell device 103, and so that the residual ratio was 100% with respect to the surface area of the solar cell device 103 before modularization without voids and flowage after the heat cycle test, that is, the condition was good.

### (Example 6)

A polyester spunbond having a different apparent density was used as the organic nonwoven fabric for the porous body 104. The solar cell module was made in the same manner as Example 1 except for that point.

### (Result)

The solar cell module after the lamination molding was molded so that the white lower sealing portion 101 did not protrude to the solar light irradiation surface of the solar cell device 103, and so that the residual ratio was 100% with respect to the surface area of the solar cell device 103 before modularization without voids and flowage after the heat cycle test, that is, the condition was good.

### (Example 7)

A polyester spunbond having a different apparent density was used as the organic nonwoven fabric for the porous body 104. The solar cell module was made in the same manner as Example 1 except for that point.

### (Result)

The solar cell module after the lamination molding was molded so that the white sealing material of the lower sealing portion 101 did not protrude to the solar light irradiation surface of the solar cell device 103, and so that the residual ratio was 100% with respect to the surface area of the solar cell device 103 before modularization without voids and flowage after the heat cycle test, that is, the condition was good.

### (Comparative Example 1)

The solar cell module was obtained by vacuum lamination molding using the two sealing materials used in Example 1 without the lamination of the organic nonwoven fabric as the porous body 104. Conditions were the same as Example 1 except for that point.

### (Result)

The solar cell module after the lamination molding was molded so that the white sealing material of the lower sealing portion 101 protruded to the solar light irradiation surface of the solar cell device 103, and the light collection area was 7% reduced with respect to the surface area of the solar cell device 103 before modularization. Accordingly, the power generation efficiency was deteriorated.

### (Comparative Example 2)

Polyethylene with a transparency of 91%, a solubility parameter SP value of 8.0 was used for the sealing material of the upper sealing portion 102, a white sealing material obtained by allowing the ethylene-vinyl acetate copolymer to contain 5wt% titanium dioxide (SP value 11.5, total light reflectance 81%) was used for the sealing material of the lower sealing portion 101, and further, a polyethylene meltblown nonwoven fabric with a fiber diameter of 15µm was used for the porous body 104 to thereby obtain the solar cell module. Conditions were the same as Example 1 except for that point.

### (Result)

In the obtained solar cell module, infiltration and affinity of the EVA resin were not good as the SP values of the polyethylene meltblown nonwoven fabric and the EVA resin are 1.0 or more, as a result, peeling occurred at an interface between the meltblown nonwoven fabric and the EVA sealing material in the heat cycle reliability test.

### (Comparative Example 3)

A meltblown nonwoven fabric with polyester extremely thin fibers was used as the organic nonwoven fabric for the porous body 104, and the EVA resin was used for the sealing material of the lower sealing portion 101 and the sealing material of the upper sealing portion 102 to thereby obtain the solar cell module by the vacuum lamination molding. Conditions were the same as Example 1 except for that point.

### (Result)

The solar cell module after the lamination molding was molded so that the white sealing material of the lower sealing portion 101 did not protrude to the solar light irradiation surface of the solar cell device 103, however, voids were found in the central part when checking voids by SAT. Furthermore, voids were grown as compared with the state before the heat cycle test when checking voids again after performing the heat cycle test in that state.

### (Comparative Example 4)

A polyester needle nonwoven fabric with a different fiber diameter was used as the organic nonwoven fabric for the porous body 104. The solar cell module was obtained in the same manner as Example 1 except for that point.

### (Result)

The obtained solar cell module was molded so that the white resin of the lower sealing portion 101 covered the solar light irradiation surface of the solar cell device 103, therefore, the irradiation area was reduced.

### (Comparative Example 5)

A polyester spunbonded nonwoven fabric with a different apparent density was used as the organic nonwoven fabric for the porous body 104. The solar cell module was obtained in the same manner as Example 1 except for that point.

### (Result)

As a fabric density of the organic nonwoven fabric for the porous body 104 is 0.05g/cm³ or less in the obtained solar cell module, the sealing material of the lower sealing portion 101 and the sealing material of the upper sealing portion 102 tend to flow into the organic nonwoven fabric for the porous body 104, and the solar cell module was molded so that the white resin as the sealing material for the lower sealing portion 101 covered the solar light irradiation surface of the solar cell device 103 in the lamination process, therefore, the irradiation area was reduced.

### (Comparative Example 6)

The solar cell module was obtained in the same manner as Example 1 except that a polyester spunbonded nonwoven fabric with a different apparent density was used as the organic nonwoven fabric. Conditions were the same as Example 1 except for that point.

### (Result)

Though the obtained solar cell module was molded so that the white resin as the sealing materials for the lower sealing portion 101 did not cover the solar light irradiation surface of the solar cell device 103, voids were generated at an interface between the upper sealing portion 102 and the lower sealing portion 101 when performing the heat cycle reliability test.

### (SP values)

The smaller the difference of SP values between the sealing material for the upper sealing portion 102 and the sealing material for the lower sealing portion 101 is, the better the adhesion is. In Comparative Example 2, as the difference between the SP value of the sealing material for the lower sealing portion 101 and the SP value of the sealing material of the organic nonwoven fabric for the porous body 104 is 3.5, the infiltration property of the sealing material for the lower sealing portion 101 with respect to the organic nonwoven fabric for the porous body 104 is not good, and the affinity is also low, therefore, the flowage may occur after the lamination molding or the heat cycle exposure, and further, void generation due to the peeling as well as peeling at an end portion may occur.

On the other hand, two kinds of fibers are used as the organic nonwoven fabric for the porous body 104 though the difference of SP values between sealing resins is 3.5 in Example 3. The porous body 104 is formed by using PET type fibers with the SP values of 10.7 and 8.0 by being mixed and entangled, which have higher affinity respectively with respect to the sealing material for the upper sealing portion 102 with the SP value of 11.5 and the sealing material for the lower sealing portion 101 with the SP value of 8.0, therefore, the affinity between the porous body 104 and the sealing materials is increased and the infiltration property is increased to thereby reduce the generation of voids, which suppresses flowability of the sealing materials at the high temperature.

It is at least necessary that the difference of SP values between the sealing materials for the lower sealing portion 101 as well as the sealing material for the upper sealing portion 102 and the organic nonwoven fabric for the porous body 104 is 0.8 or less.

The following both differences are required to be 0.8 or less, that is, the difference between the SP value of a fiber having a higher SP value in the organic nonwoven fabric as the porous body 104 and the SP value of a sealing material having a higher SP value in the lower sealing portion 101 and the upper sealing portion 102, that is, the difference between the SP value of a fiber having a lower SP value in the organic nonwoven fabric as the porous body 104 and the SP value of a sealing material having a lower SP value in the lower sealing portion 101 and the upper sealing portion 102.

In short, the firm solar cell module having good adhesion between respective fibers and the sealing resins can be obtained.

When two or more kinds of fibers are used, the above can be applied by the comparison using the highest SP value and the smallest SP value.

The difference of SP values between the sealing material for the lower sealing portion 101 and the sealing material for the upper sealing portion 102 is at least lower than 3.5, and is preferably 1.0 or less which is approximately equal to 0.8 from the results as the plural fibers described above according to the comparisons in Comparative Example 2 and Example 3.

### (Fiber Diameter)

As can be seen from Example 4 and Comparative Example 3, when the fiber diameter of the organic nonwoven fabric for the porous body 104 is lower than 10µm, the nonwoven fabric tends to be dense as fibers forming the fabric are thin, as a result, the sealing materials are not easily infiltrated into the porous material 104 from both sides at the time of the vacuum lamination in the process of modularization.

The apparent density also differs in addition to the fiber diameter in Example 4 and Comparative Example 3. The apparent density is preferably 0.05 to 0.30g/cm³ as described below, and the apparent densities in Example 4 and Comparative Example 3 are within this range as well as the difference is small and does not affect the result.

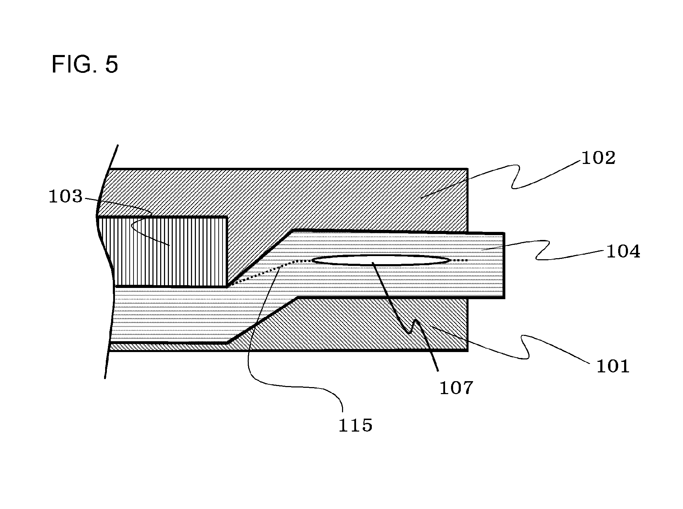

Fig. 5 is a view corresponding to Fig. 2A, showing a cross-sectional view of a solar cell module in which a void 107 is involved inside the organic nonwoven fabric as the porous body 104. Such failure tends to occur when the fiber diameter is smaller than 10µm. Conversely, when the fiber diameter is larger than 100µm, it is not preferable because the void between fibers becomes too large and the sealing material can be easily passed therethrough, which causes the flowage of the sealing material through the nonwoven fabric as can be seen from Example 5 and Comparative Example 4. Accordingly, it is necessary that the fabric diameter is 10µm or more to 100µm or less.

### (Fiber Apparent Density)

As can be seen from Example 6 and Comparative Example 5, when the fiber apparent density is lower than 0.05g/cm³, the organic nonwoven fabric as the porous body 104 becomes a fabric with a small amount of fibers and a large number of voids, therefore, it is not preferable because the sealing material is easily passed through the organic nonwoven fabric and the flowage of the sealing material occurs at the time of heating in the laminating process or in use. The fabric apparent density requires to be 0.05g/cm³ or more.

Though the fabric diameter also differs in addition to the apparent density in Example 6 and Comparative Example 5, the difference is small as well as the diameters are within the necessary range, which does not affect characteristics.

Conversely, when the fiber apparent density is higher than 0.30g/cm³, the organic nonwoven fabric as the porous body 104 tends to be dense as can be seen from Example 7 and Comparative Example 6, and it is not suitable because the infiltration of the sealing members into the porous body 104 becomes worse and the void 107 tends to occur inside the porous body 104 as shown in Fig. 5. The fiber apparent density requires to be 0.30g/cm³ or less.

Though the fabric diameter also differs in addition to the apparent density in Example 6 and Comparative Example 5, the difference is small as well as the diameters are within the necessary range, which does not affect characteristics.

Accordingly, the fiber apparent density is required to be 0.05g/cm³ or more to 0.30g/cm³ or less.

The opening 114 is provided in the organic nonwoven fabric as the porous body 104 only in Embodiment 2, however, the relation in the example can be similarly applied to examples not having the opening 114.

Though the case where two kinds of fibers are applied has been cited, the same result can be obtained also when using two or more kinds of fibers.

The organic nonwoven fabric has been mainly explained as the porous body 104, however, sheet type porous bodies such as a woven fabric of fibers and a resin sheet provided with many openings may be applied in addition to the nonwoven fabric.

The woven fabric of fibers has uniform and three-dimensional openings, which is suitable as the resin can easily enter the fabric. The nonwoven fabric is further suitable as it has irregular fibers and various openings, therefore, the resin can easily enter the fabric.

Embodiments 1 and 2 can be combined as long as there is no hindrance.

### INDUSTRIAL APPLICABILITY

The present invention can be used for the solar cell module.

### REFERENCE SIGNS LIST

- 101: lower sealing portion
- 102: upper sealing portion
- 103: solar cell device
- 104: porous body
- 105: uppermost protective member
- 106: back sheet
- 107: void
- 110: protruding portion
- 114: opening
- 115: interface

## Claims

1. A solar cell module comprising:
a back sheet;
a first sealing portion positioned over the back sheet;
a porous body provided over the first sealing portion;
a solar cell device positioned over the porous body;
a second sealing portion positioned over the solar cell device; and
an outer protective portion positioned over the second sealing portion.

2. A solar cell module comprising:
a back sheet;
a first sealing portion positioned over the back sheet;
a porous body provided over the first sealing portion and having a through hole;
a solar cell device positioned over the first sealing portion and positioned in the through hole;
a second sealing portion positioned over the first sealing portion and the solar cell device; and
an outer protective portion positioned over the second sealing portion.

3. The solar cell module according to any one of claims 1 and 2,
wherein the porous body, the first sealing portion and the second sealing portion have a sheet shape,
the porous body has a larger area than the first sealing portion and the second sealing portion, and
the first sealing portion and the second sealing portion do not directly contact each other in side surfaces of an outer periphery of the solar cell module.

4. The solar cell module according to any one of claims 1 and 2,
wherein a first sealing material of the first sealing portion and a second sealing material of the second sealing portion enter the porous body to connect the first sealing portion to the second sealing portion.

5. The solar cell module according to any one of claims 1 to 4,
wherein the porous body is a knitted fabric of fibers.

6. The solar cell module according to any one of claims 1 to 4,
wherein the porous body is an organic nonwoven fabric.

7. The solar cell module according to claim 6,
wherein the organic nonwoven fabric is made of polyethylene terephthalate fibers, polyolefin fibers, or these two kinds of fibers, and
sealing materials in the first sealing portion and the second sealing portion include at least one of an ethylene-unsaturated carboxylic acid copolymer or an ionomer thereof, a silicone resin, polyvinyl-butyral, a thermoplastic polyurethane resin, a polyolefin resin.

8. The solar cell module according to claim 6,
wherein a fiber diameter in the organic nonwoven fabric is 10µm or more to 100µm or less and a fiber apparent density is 0.05g/cm³ or more to 0.30g/cm³ or less.

9. The solar cell module according to claim 6,
wherein the difference of solubility parameter SP values between the first and second sealing materials and the fibers in the organic nonwoven fabric is 1.0 or less.

10. The solar cell module according to claim 6,
wherein the organic nonwoven fabric is formed by entangling two kinds of organic fibers,
the difference between a solubility parameter SP value of the first sealing material and a solubility parameter SP value of a first fiber forming the organic nonwoven fabric is 0.8 or less, and
the difference between a solubility parameter SP value of the second sealing material and a solubility parameter SP value of a second fiber forming the organic nonwoven fabric is 0.8 or less.
